# EUROPEAN PATENT APPLICATION

(11) **EP 4 808 341 A2**
(43) Date of publication of application: **16.09.2026**
(21) Application number: 26164203.7
(22) Date of filing: 12.03.2026
(51) Int. Cl.: H10W 90/10, H10W 90/20, H10W 90/22

(54) **STACKED BACK-TO-BACK POWER MODULES AND METHOD OF MANUFACTURING**

(30) Priority: 13.03.2025 US 202563771259 P; 13.03.2025 US 202563771248 P
(71) Applicant: General Electric Company, Cincinnati, Ohio 45215 (US)
(72) Inventor: GOWDA, Arun Virupaksha, Niskayuna, 12309-1027 (US); HAQUE, Md Ehsanul, Niskayuna, 12309-1027 (US); BENIWAL, Neha, Niskayuna, 12309-1027 (US)
(74) Representative: Openshaw & Co.

(57) **Abstract**

An electronic component (100) includes a first subassembly (102) and a second subassembly (130). The first subassembly (102) includes a first power overlay (POL) (104) that provides electrical connections to at least one semiconductor device (112) included in the first subassembly (102). The second subassembly (130) includes a second POL (132) that provides electrical connections to at least one semiconductor device (140) included in the second subassembly (130). The second subassembly (130) is disposed over the first subassembly (102) with the second POL (132) oriented toward the first POL (104) and with electrical connections between the first and second subassemblies (102)(130) that form a power module.

## Description

### CROSS-REFERENCE TO RELATED APPLICATIONS

This application claims the benefit of U.S Provisional Patent App. No. 63/771,248, filed March 13, 2025, and U.S. Provisional Patent App. No. 63/771,259, filed March 13, 2025, which are both hereby incorporated by reference herein.

### TECHNICAL FIELD

These teachings relate generally to power modules and more particularly to stacked back-to-back power modules and methods of manufacturing such stacked back-to-back power modules.

### BACKGROUND

A power module or power electronic module is an assembly including several power components that are internally interconnected to perform a power conversion function. The power components in power modules are typically power semiconductor devices. Within power modules, these semiconductor devices must be internally connected to perform a power conversion.

### BRIEF DESCRIPTION OF DRAWINGS

Various needs are at least partially met through provision of the stacked back-to-back power modules and methods of manufacturing described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a schematic of a back-to-back power module, which can be used to build a solid-state circuit breaker;
FIGS. 2-9 are schematic cross-sectional side views of stacked back-to-back power modules in accordance with various embodiments of these teachings;
FIG. 10 is a flowchart of a method of manufacturing a stacked back-to-back power module of FIGS. 2-9 in accordance with various embodiments of these teachings;
FIG. 11 is a schematic cross-sectional side view of a stacked back-to-back power module in accordance with various embodiments of these teachings;
FIGS. 12 and 13 are schematic diagrams of back-to-back power modules each connected in parallel with a metal-oxide varistor (MOV) in accordance with various embodiments of these teachings; and
FIGS. 14-16 are schematic diagrams of converters with the stacked back-to-back power modules in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

Generally speaking, the various aspects of the present disclosure can be employed with a power module or power electronic module including several power components that are interconnected to perform a power conversion function, such as, for example, power semiconductor devices. More specifically, in some embodiments, these internal connections can be made using power overlays (POLs), which are formed of dielectric layers and metal interconnects electroplated onto the dielectric layers to form direct metallic connections to the power semiconductor devices. The metal interconnects may be in the form of a low profile (e.g., less than 1000 micrometers thick), planar interconnect structure that provides for formation of an input/output (I/O) system to and from the power semiconductor device(s).

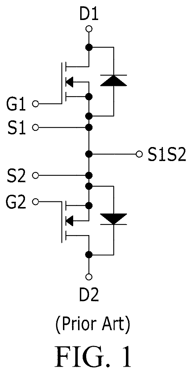

One type of power module is a solid-state circuit breaker power module. As compared to traditional mechanical circuit breakers that utilize mechanical components to trip a circuit when a fault occurs, solid-state circuit breakers use electronic components to interrupt current flow when a fault is detected. FIG. 1 illustrates a schematic diagram of a solid-state circuit breaker circuit building block that includes two anti-parallel or inverse parallel switch-diode pairs connected in back-to-back fashion, each including a respective source S1, S2, drain D1, D2, and gate G1, G2. The drain D1 of the first switch-diode pair and drain D2 of the second switch-diode pair can be connected to a direct current (DC) or alternating current (AC) bus (not shown). Source S1 of the first switch-diode pair is coupled to source S2 of the second switch-diode pair to create a midpoint S1S2 or S1/S2 that may be coupled to or integrated with an AC power source or load. When activated, the solid-state circuit breaker will prevent current from flowing across either the first or second switch-diode pair.

Power modules can be used in a variety of industries such as, for example, the aviation industry or automotive industry. In these industries, there is a constant drive to increase power density and efficiency of power converters. Currently, these industries are solving the power density and efficiency problem by improving the power semiconductor devices themselves and improving the packaging, such as via sintered silver die attachment and double-side cooled modules. However, these solutions leave much room for improvement in terms of area occupied by power modules. Accordingly, the electronic component and methods of manufacturing thereof as described herein form a power module with an increased power density and efficiency.

In some embodiments, the various aspects of the present disclosure provide an electronic component that forms a power module created by stacking two power overlay (POL) subassemblies on top of each other such that the source of a first or bottom POL subassembly is attached to the source of a second or top POL subassembly. This creates a three-dimensional (3D) stacked drain-source-source-drain or back-to-back topology. Integrating this topology as stacked back-to-back power modules enables the stacked back-to-back power modules to act as bidirectional solid state circuit breakers. Stacking the two POL subassemblies additionally reduces the module footprint size and the parasitics (inductance and resistance) within the module, leading to a higher power density (kW/cm3). In some embodiments, the stacked back-to-back power modules also include the addition of voltage clamping or surge protection devices, such as, for example, metal-oxide varistors (MOVs) or transient voltage suppressors within the 3D structure in a low inductance circuit. A heatspreader and/or cooling channel can be included between the two stacked POL subassemblies to improve the thermal management of the module.

In some embodiments, an electronic component includes a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL oriented toward the first POL and with electrical connections between the first and second subassemblies that form a power module.

In some embodiments, a method includes fabricating a first subassembly that includes a first power overlay (POL) that provides electrical connections to at least one semiconductor device included in the first subassembly; fabricating a second subassembly that includes a second POL that provides electrical connections to at least one semiconductor device included in the second subassembly; and coupling the second subassembly to the first subassembly such that the second subassembly is disposed over the first subassembly with the second POL oriented toward the first POL and with electrical connections between the first and second subassemblies that form a power module.

In some embodiments, an electronic component includes a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL and the first POL oriented such that they face substantially opposite directions and with electrical connections between the first and second subassemblies that form a power module.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description.

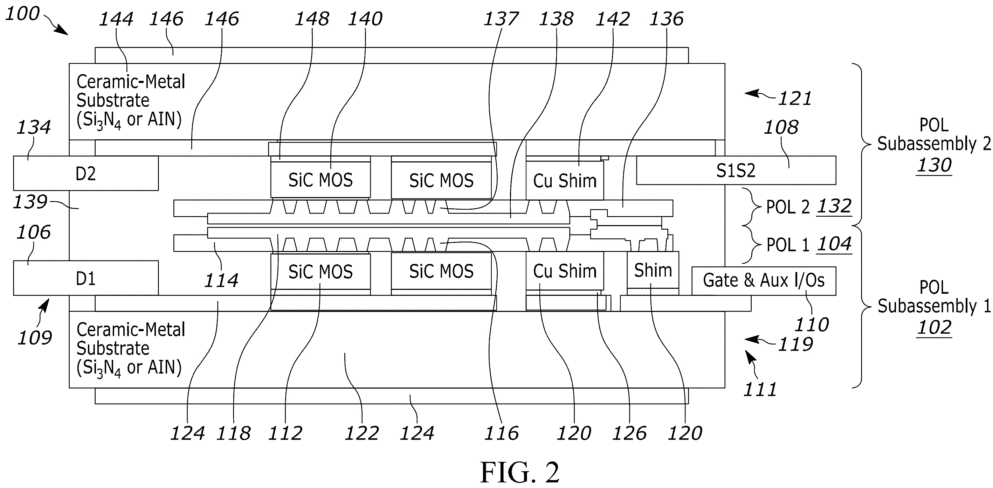

Referring now to the drawings, and in particular to FIGS. 2-9, schematic cross-sectional side views of electronic components are shown according to various embodiments of these teachings. In some embodiments, the electronic components of FIGS. 2-9 may be used for implementing power modules having a stacked back-to-back drain-source-source-drain (D-S-S-D) configuration. Generally, the electronic components of FIGS. 2-9 include the same base components of a first subassembly 102 and a second subassembly 130 with electrical connections between the first and second subassemblies that form a power module. The second subassembly 130 is disposed over the first subassembly 102 with the second power overlay (POL) 132 oriented toward the first POL 104 and with electrical connections between the first and second subassemblies that form a power module. Thus, in some embodiments, the power module is formed by stacking the first and second subassemblies 102, 130 on top of each other.

In some embodiments, the first and second POLs 104, 132 can be said to be arranged in a substantially face-to-face orientation. This is because, in some embodiments, the second POL 132 is initially fabricated to be similar to the first POL 104, and then the second POL 132 is flipped over (or turned upside down) and then stacked onto the first POL 104. This results in the second POL 132 being oriented toward, or facing, the first POL 104. That is, in some embodiments, the second subassembly 130 is oriented, rotated, and/or positioned such that the second POL 132 is disposed onto the first POL 104 of the first subassembly 102.

In some embodiments, the source of the first or bottom subassembly 102 is attached to the source of the second or top subassembly 130. This creates a three-dimensional (3D) stacked drain-source-source-drain or back-to-back topology, enabling the stacked back-to-back power module to act as a bidirectional solid state circuit breaker.

The first subassembly 102 includes a first power overlay (POL) 104 that provides electrical connections to at least one semiconductor device 112 included in the first subassembly 102. The first subassembly 102 may also include a drain (D1) lead 106 and gate/auxiliary (I/Os) leads 110. The second subassembly 130 includes a second power overlay (POL) 132 that provides electrical connections to at least one semiconductor device 140 included in the second subassembly 130. The second subassembly 130 may also include a drain (D2) lead 134 and a midpoint (S1S2) lead 108 (discussed below). In some embodiments, the internal routing of the gate/auxiliary connections within the electronic component that forms the power module may be arranged such that the gate/auxiliary (I/Os) leads 110 are located only on one subassembly, which in the illustrated case is on the first subassembly 102. In some embodiments, the gate/auxiliary (I/Os) leads 110 may be located only on the second subassembly 130, or a combination of both the first and second subassemblies 102, 130.

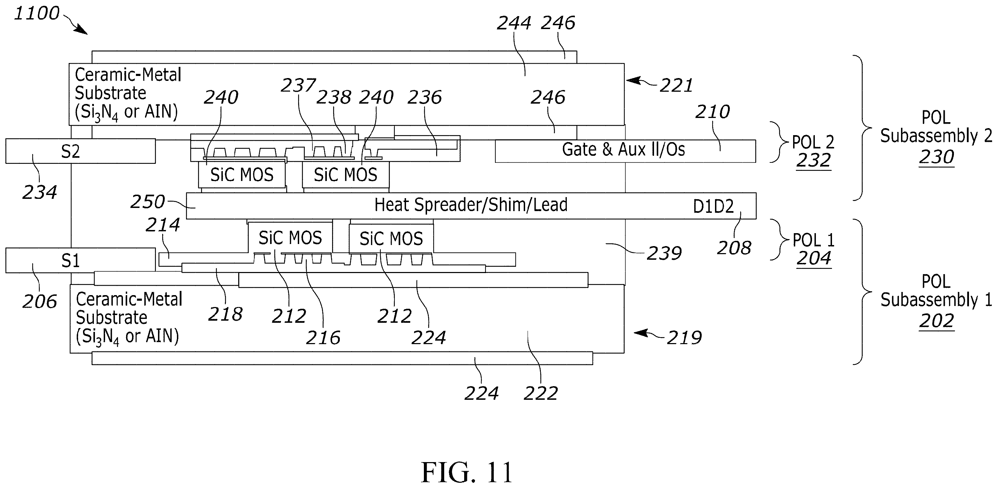

In some embodiments, the source (S1) of the first subassembly 102 is coupled to the source (S2) of the second subassembly 130 such that the electronic component includes the midpoint (S1S2) lead 108, which enables the stacked back-to-back power module to act as a bidirectional solid state circuit breaker. However, as will be discussed below with respect to FIG. 11, in some embodiments, the drain (D1) of the first subassembly 102 is coupled to the drain (D2) of the second subassembly 130 such that the electronic component includes a midpoint (D1D2) lead. The leads may be implemented as pins, tabs, or other conductive terminals, and may be formed from and/or supported by leadframes. The leadframes may have a structure formed of copper or another conductive metal or metal alloy. The leadframes may be used as power, gate, or auxiliary terminals/pins and, in some embodiments, may provide the planes for attaching power semiconductor devices and/or POLs. The stacked configuration of the electronic modules in FIGS. 2-9 provide for the drain (D1) lead 106 and drain (D2) lead 134 to overlap vertically on one side of the electronic component rather than having to be spaced apart from each other in the same horizontal plane. The configurations of the electronic components (e.g., configured as back-to-back power modules) of FIGS. 2-9 allow more power to be added with respect to a side-by-side back-to-back power module of the same size.

The first subassembly 102 and the second subassembly 130 each include power semiconductor devices 112, 140, respectively. In the illustrated embodiments, the power semiconductor devices include silicon carbide (SiC) metal-oxide-semiconductor field-effect transistors (MOSFETs) though any suitable power semiconductor device can be used (e.g., Si IGBTs, GaN HEMTs, etc.). The first and second power overlay (POL) 104, 132 of the first and second subassembly 102, 130 provides connections to the at least one semiconductor device included in the respective subassembly. In some embodiments, the semiconductor devices included in each of the first and second subassemblies can be configured into an anti-parallel switch-diode pair.

The first POL 104 of the first subassembly 102 includes one or more dielectric layers 114 having conductive vias 116 and patterned metal interconnects 118 formed thereon. The metal interconnects 118, e.g., formed of copper or copper alloys, can be patterned to define the desired routing paths across the first POL 104 to route electrical signals and power between terminals of the least one power semiconductor device 112 and external leads. The vias 116 are conductive openings formed through the dielectric layers 114 to electrically connect different levels of the interconnect structure, enabling vertical signal and power routing between terminals of the power semiconductor device 112 and the drain/source leads or leadframes. The vias 116 may be filled or plated with conductive materials such as copper to ensure low-resistance electrical continuity. Copper shims 120 are positioned within the first subassembly 102 to enhance both electrical conduction and thermal dissipation. The power semiconductor devices 112 of the first POL 104 are mounted on a first substrate structure 119 that includes a ceramic-metal substrate 122, which may be formed from thermally conductive and electrically insulating materials such as silicon nitride (Si₃N₄) or aluminum nitride (AIN). The substrate 122 can include copper layers 124 on both its top and/or bottom surfaces, forming a direct bonded copper (DBC) substrate to facilitate efficient thermal dissipation and electrical conduction. In some embodiments, the power semiconductor devices 112 are bonded (e.g., mechanically and electrically) to the first substrate structure 119 using a high-performance attachment layer 126, which may include sintered silver, conductive adhesives, or solder materials such as tin-lead, pure tin, tin-silver, or tin-copper alloys.

The second POL 132 of the second subassembly 130 includes one or more dielectric layers 136 having conductive vias 137 and patterned metal interconnects 138 formed thereon. The metal interconnects 138, e.g., formed of copper or copper alloys, can be patterned to define the desired routing paths across the second POL 132 to route electrical signals and power between terminals of the least one power semiconductor device 140 and external leads. The vias 137 are conductive openings formed through the dielectric layers 136 to electrically connect different levels of the interconnect structure, enabling vertical signal and power routing between terminals of the power semiconductor device 140 and the drain/source leads or leadframes. The vias 137 may be filled or plated with conductive materials such as copper to ensure low-resistance electrical continuity. Copper shims 142 are positioned within the second subassembly 130 to enhance both electrical conduction and thermal dissipation. In some embodiments, the second POL 132 is implemented as an overmolded structure that integrates the dielectric layers 136 and the metal interconnects 138 into a compact, planar interconnection system for low-profile, high-density routing of gate, source, and drain terminals, while also supporting efficient thermal and electrical performance within the architecture of the electronic component. The power semiconductor devices 140 of the second POL 132 are mounted on a second substrate structure 121 that includes a ceramic-metal substrate 144, which may be formed from thermally conductive and electrically insulating materials such as silicon nitride (Si₃N₄) or aluminum nitride (AIN). The substrate 144 can include copper layers 146 on both its top and/or bottom surfaces, forming a direct bonded copper (DBC) substrate to facilitate efficient thermal dissipation and electrical conduction. In some embodiments, the power semiconductor devices 140 are bonded (e.g., mechanically and electrically) to the second substrate structure 121 using a high-performance attachment layer 148, which may include sintered silver, conductive adhesives, or solder materials such as tin-lead, pure tin, tin-silver, or tin-copper alloys.

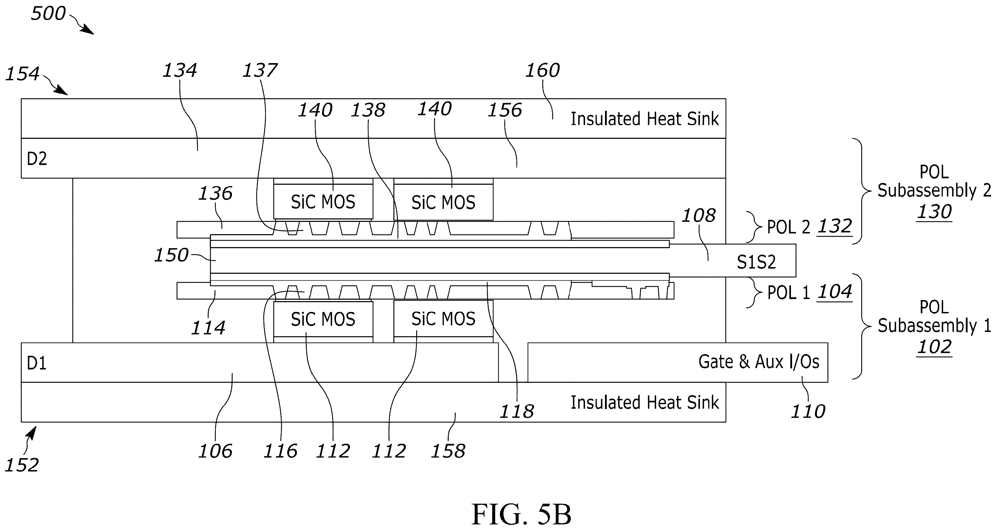

As mentioned above, in some embodiments, the first and second POLs 104, 132 can be said to be arranged in a substantially face-to-face orientation. In some embodiments, fabricating the modules so that the POLs 104, 132 physically face each other can be helpful for a D-S-S-D configuration because the sources may be relatively close together. This is because, in some embodiments, the sources of the semiconductor devices 112 may be near the vias 116, and the sources of the semiconductor devices 140 may be near the vias 137, which are all in relatively close proximity due to the face-to-face orientation. This is somewhat more evident in FIG. 5B with its placement of the midpoint (S1S2) lead 108, which will be discussed below.

In some embodiments, at least one of the first and second subassemblies 102, 130 of the electronic component 100 may omit a substrate structure (thus omitting a ceramic substrate) and, therefore, may have at least one non-insulated side, which is formed of a leadframe. Generally, the leadframes forming the non-insulated sides of the electronic component 100 are made of copper, but may be formed of other metals or metal alloys in various embodiments.

In some embodiments, the first and second POL 104, 132 may be implemented as overmolded structures. In some embodiments, overmolding is performed after the first and second subassemblies 102, 130 are stacked and electrically coupled. In other embodiments, each of the first and second subassemblies 102, 130 may be overmolded separately prior to stacking. In such configurations, after the overmolded subassemblies are stacked and electrically interconnected, additional insulating or encapsulating material may be introduced to fill gaps between the subassemblies and around the electrical interconnections. In some embodiments, an insulating material 139 may be used to at least partially fill gaps between and around the first and second subassemblies 102, 130.

Attachment of different components may be performed using sintering (with silver, as a non-limiting example) or soldering (with tin/lead, tin/silver/copper, as non-limiting examples) based on the desired characteristics of the bonds.

The specific components and materials indicated above and in FIGS. 2-9 are non-limiting and vary between embodiments. The differences between the electronic components of FIGS. 2-9 lie in the particular arrangements of these components, additional components, or removal of components, as shown in FIGS. 2-9 and described below. The variability of the design for the electronic components shows how the design of the electronic components which form power modules can be tailored for different applications.

Referring now to FIG. 2, the electronic component 100 of FIG. 2 includes the first subassembly 102 with the drain (D1) lead 106 extending from a first side 109, and the gate and auxiliary input and output (I/O) leads 110 extending from an opposing second side 111. The second subassembly 130 includes the drain (D2) leads 134 extending from the first side 109 and the midpoint (S1S2) lead 108 extending from the opposing second side 111. The second subassembly 130 is disposed over the first subassembly 102 with the second POL 132 oriented toward the first POL 104. Electrical connections are formed between the first and second subassemblies 102, 130 to form a stacked back-to-back power module. In some embodiments, the electrical coupling between the metal interconnects 118 of the first subassembly 102 and the metal interconnects 138 of the second subassembly 130 is achieved via a sintered attachment.

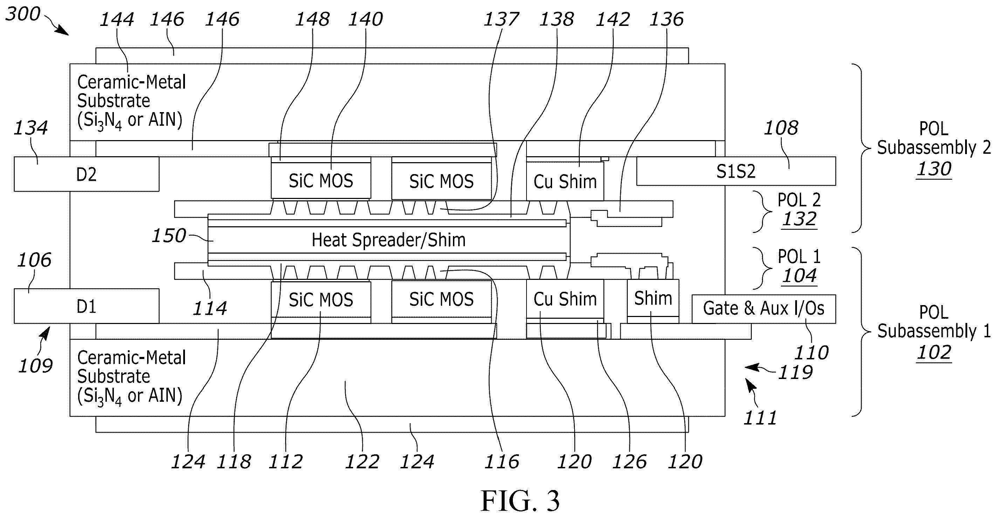

Referring to FIG. 3, an electrical component 300 is shown in accordance with some embodiments. The electrical component 300 is similar in many respects to the electrical component 100 of FIG. 2. The same part numbers refer to the same or similar components as those described in FIG. 2 and only general differences will be discussed.

As shown in FIG. 3, the electrical component 300 includes a heatspreader or shim 150 positioned between the first subassembly 102 and the second subassembly 130. The heatspreader or shim 150 (which forms an intermediate layer) may enhance thermal management by facilitating heat dissipation away from the power semiconductor devices 112, 140 during operation. In some embodiments, the heatspreader 150 is sintered to the metal interconnects 118, 138 of the first and second subassemblies 102, 130. In some embodiments, the heatspreader or shim 150 can be formed from copper or another high thermal conductivity material and may also serve as a mechanical spacer to optimize the vertical alignment of the stacked back-to-back structure. In addition, or as an alternative to the heatspreader or shim, a cooling channel can be incorporated into the electrical component 300. The cooling channel may be configured to accommodate fluid or air flow to improve thermal performance by enabling active heat removal from the interior of the stacked module.

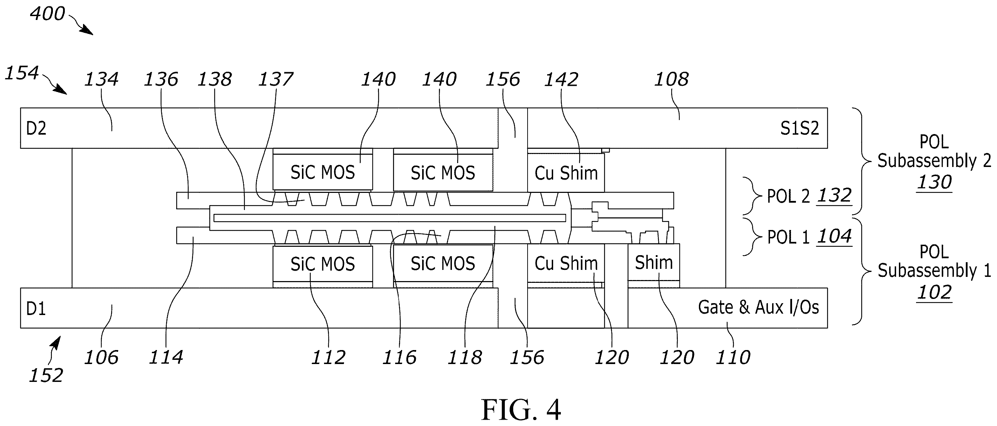

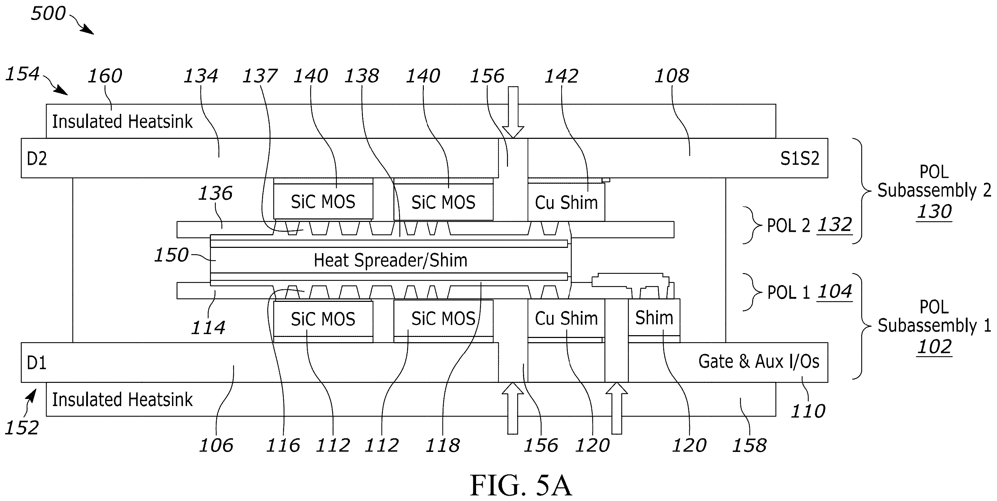

Referring now to FIGS. 4, 5A and 5B, electrical components 400, 500, 550 are shown in accordance with some embodiments. The electrical components 400, 500, 550 are similar in many respects to the electrical component 100 of FIG. 2. The same part numbers refer to the same or similar components as those described in FIG. 2 and only general differences will be discussed.

As shown in FIGS. 4-5B, the electronic components 400, 500, 550 differ from those in FIGS. 2 and 3, respectively, in that the electrical components 400, 500, 550 do not include a substrate structure and thus do not include a ceramic substrate. In other words, the electrical components are non-insulated and include only leadframes on their top sides 152 and bottom sides 154. In some embodiments, either only the top sides 152 or only the bottom sides 154 of the electronic components 400, 500, 550 are non-insulated. The non-insulated side(s) of the electronic components 400, 500, 550 of FIGS. 4-5B may be incorporated into any of the other electronic component embodiments. This approach removes the ceramic layer on one or both sides of the stack, which can reduce manufacturing complexity and improve thermal conduction from the electronic components to external environment.

In some embodiments, the electronic components 400, 500 include cooling channels 156 to improve thermal management of the electronic component. In addition, or alternatively, the electronic components 400, 500 can include a thermally conductive, electrically insulating, layer between the electronic components (e.g., the back-to-back or stacked first and second subassemblies 102, 130) and a metal heatsink structure.

In some embodiments, as shown in FIGS. 5A-5B, the electronic components 500, 550 additionally include the heatspreader or shim 150 of FIG. 3 positioned between the first and second subassemblies 102, 130. In addition, a first insulated ceramic heatsink 158 is disposed on the first subassembly 102 on the bottom side 152 and a second insulted ceramic heatsink 160 is disposed on the second subassembly 130 on the top side 154. A thermally conductive insulating layer can also be applied to the top and bottom-side leadframes with the insulating ceramic heatsinks. Moreover, in some embodiments, a metal cold plate may be used with the electronic component 500. If the electronic component 500 includes this thermally conductive insulating layer, a metal cold plate may be used. If instead an electrically conductive layer is used, an insulative cold plate (for example, a ceramic cold plate) is used. In the electronic component of FIGS. 5A-5B, the cooling provided by the heatsinks and heatspreader/shim make this electronic component a double-side cooled heatsink with three cooling layers. However, the heatspreader/shim may be omitted in some embodiments.

In some embodiments, as shown in FIG. 5B, the midpoint (S152) lead 108 is positioned between the first and second subassembly 102, 130 and electrically coupled to the first POL 104 and the second POL 132. The midpoint (S1S2) lead 108 electrically interconnects the source of the power semiconductor device(s) in the first subassembly 102 with the source of the power semiconductor device(s) in the second subassembly 130, thereby forming the internal midpoint node S1S2. The midpoint lead 108 may further extend to an external interface to provide access to the midpoint. In some embodiments, the midpoint lead 108 may additionally function as a conductive shim, a thermal heat spreader, or a combined electrical-mechanical interconnect element, providing one or more of electrical coupling, thermal conduction, and structural support between the stacked subassemblies.

While not shown in FIG. 5B, it is noted that in some embodiments one or more additional conductive shims may be used to provide additional electrical coupling, thermal conduction, and/or structural support. For example, in some embodiments, the gate and auxiliary (I/O) leads 110 may be electrically coupled to the first POL 104 by way of a conductive shim in a manner similar to the copper shim 120 shown in FIGS. 4 and 5A and described above.

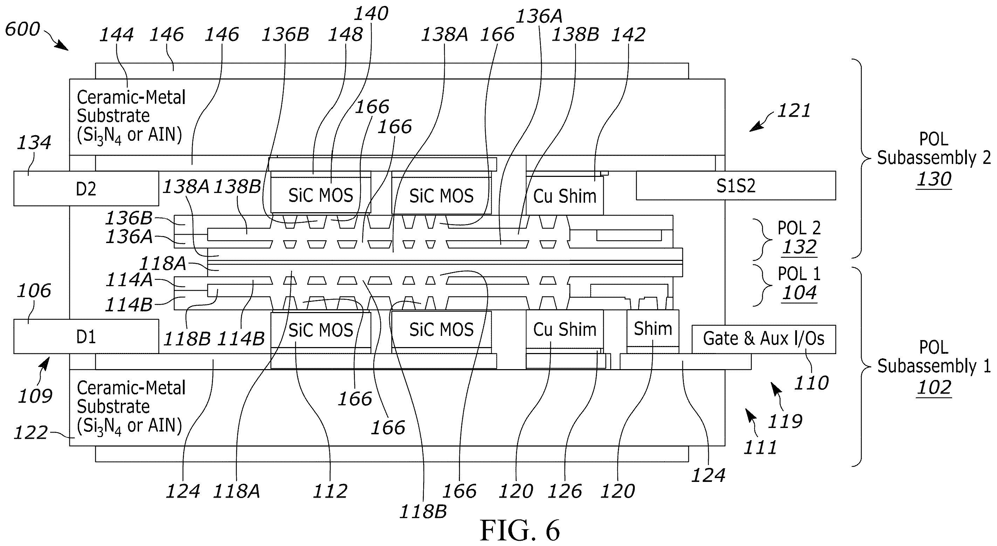

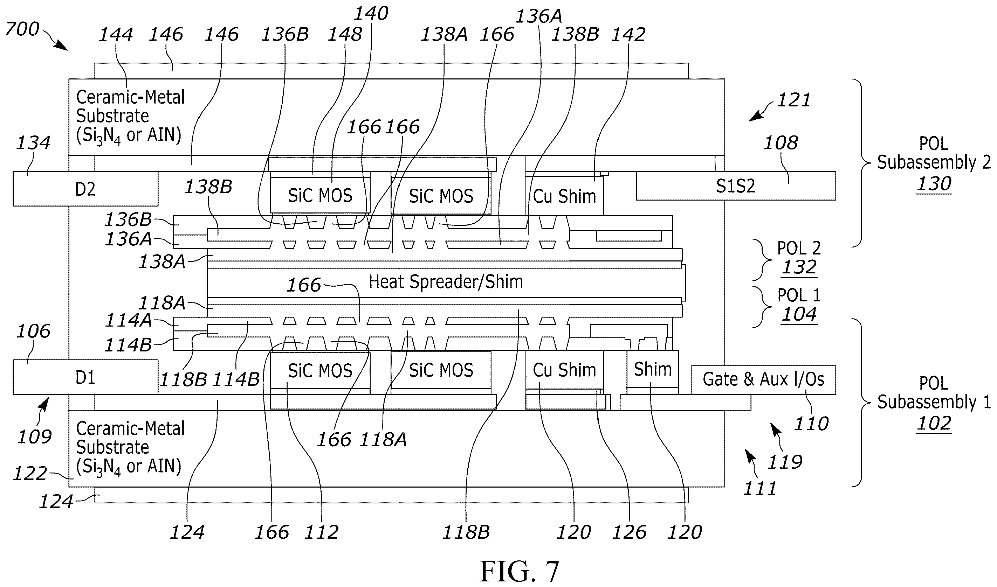

Referring now to FIGS. 6 and 7, electrical components 600, 700 are shown in accordance with some embodiments. The electrical components 600, 700 are similar in many respects to the electrical components 400, 500 of FIGS. 4 and 5. The same part numbers refer to the same or similar components as those described in FIGS. 4 and 5 and only general differences will be discussed.

As shown in FIGS. 6 and 7, the electronic components 800, 900 differ from those in FIGS. 4, 5, respectively, in that the first POL 104 and the second POL 132 are each implemented as double-layer (or two layer) POLs. More specifically, the first double-layer POL 104 includes two dielectric layers 114A and 114B, which are vertically stacked. The dielectric layer 114A has a patterned metal interconnect layer 118A formed thereon, and the dielectric layer 114B has a patterned metal interconnect layer 118B formed thereon. Similarly, the second double-layer POL 132 includes two dielectric layers 136A and 136B, which are vertically stacked. The dielectric layer 136A has a patterned metal interconnect layer 138A formed thereon, and the dielectric layer 136B has a patterned metal interconnect layer 138B formed thereon. The interconnect layers may be formed from copper or copper alloys and are patterned to route power and signal paths between the semiconductor device terminals and external leads. Vertical conductive vias 166 are formed through the dielectric layers 114A, 114B, 136A, and 136B to electrically couple the stacked interconnect layers, enabling multi-level routing within a compact footprint. The additional routing layer allows for improved separation of high-current and control signal paths, reducing electromagnetic interference and parasitic coupling. Further, the routing also enables more efficient use of the available surface area, allowing for denser integration of semiconductor devices and more flexible terminal placement. Furthermore, the double-layer configuration can simplify assembly by reducing the need for complex external wire bonds or crossovers, and may improve thermal spreading by distributing current more evenly across multiple conductive planes.

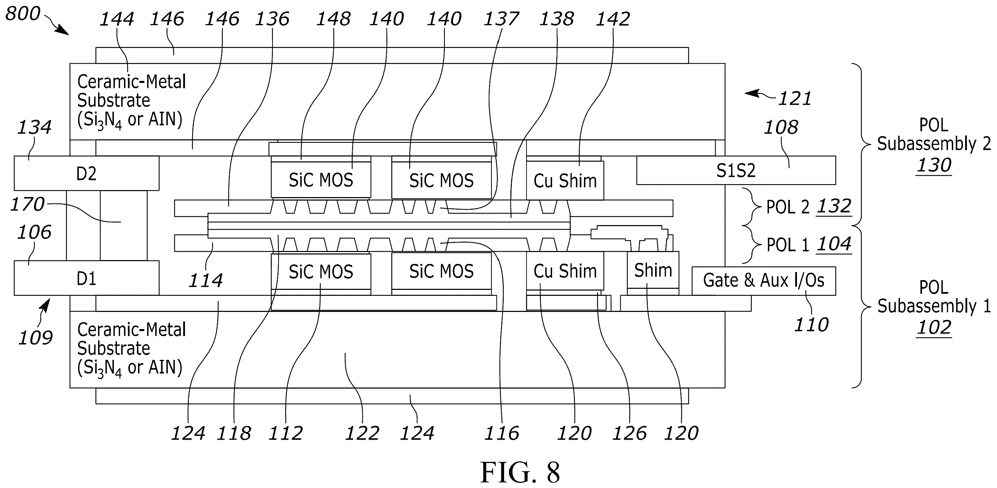

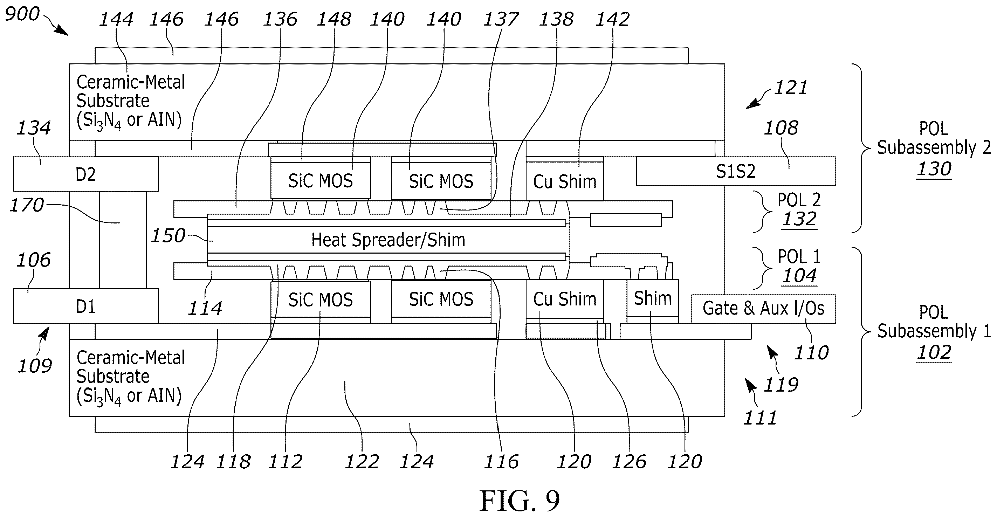

Referring now to FIGS. 8 and 9, electrical components 800, 900 are shown in accordance with some embodiments. The electrical components 800, 900 are similar in many respects to the electrical components 400, 500 of FIGS. 5 and 6. The same part numbers refer to the same or similar components as those described in FIGS. 4 and 5 and only general differences will be discussed.

As shown in FIGS. 8 and 9, the electronic components 800, 900 differ from those in FIGS. 4, 5, respectively, in that the electronic components 800, 900 further include circuity coupled between the first and second subassemblies 102, 130 configured to provide surge protection. In some embodiments, the circuity includes a metal-oxide varistor (MOV) 170 coupled between the drain (D1) lead 106 and the drain (D2) lead 134. In other embodiments, the circuity may include a transient voltage suppressor. The MOV 170 can provide voltage clamping for the electronic component. During normal operating conditions, the MOV 170 exhibits a high impedance state and draws minimal current. However, when the electronic component experiences a voltage surge that exceeds the clamping threshold of the MOV 170, the MOV 170 transitions to a low impedance state, conducting current and dissipating the surge energy to protect the internal power semiconductor devices. The MOV 170 operates in parallel with the solid-state circuit breaker functionality of the stacked back-to-back subassemblies that form the power module, thereby enhancing protection against high-voltage transients. In high-performance implementations, a snubber circuit may also be integrated within the stacked power module to reduce high-frequency voltage oscillation and improve transient response. The snubber circuit may include a combination of inductors, capacitors, and resistors arranged in parallel with the MOV 170 to further suppress voltage spikes and minimize oscillation settling time.

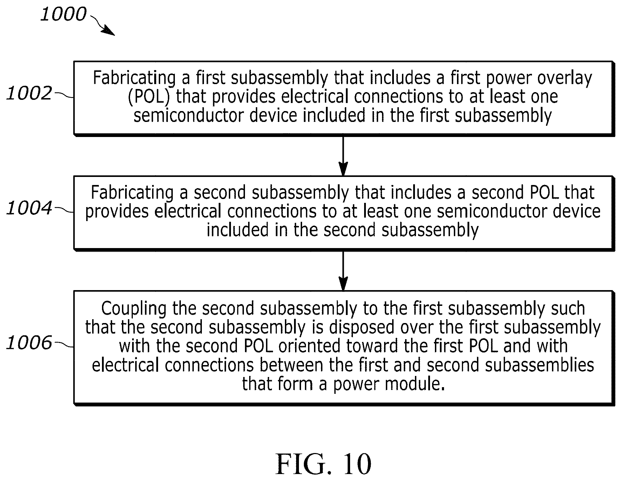

Referring to FIG. 10, a method 1000 of manufacturing an electrical component is shown in accordance with various embodiments. The method 1000 of manufacturing can be applied to manufacture the electrical component of any of the embodiments of FIGS. 2-9 described above. The method 1000 may include additional steps not shown, and the steps may be performed in any suitable order or in parallel, depending on the implementation.

At step 1002, the method 1000 includes fabricating a first subassembly that includes a first power overlay (POL). The first POL provides electrical connections to at least one semiconductor device included in the first subassembly. In some embodiments, fabricating the first subassembly includes coupling the at least one semiconductor device to a first substrate structure, such as a ceramic-metal substrate with metal layers bonded to both sides (e.g., a direct bonded copper (DBC) substrate), and coupling a first leadframe to the first substrate structure to provide external connectors for the power module.

At step 1004, the method 1000 includes fabricating a second subassembly that includes a second POL. The second POL provides electrical connections to at least one semiconductor device included in the second subassembly. In some embodiments, fabricating the second subassembly further includes coupling the at least one semiconductor device to a second substrate structure, such as a ceramic-metal substrate with metal layers bonded to both sides, and coupling a second leadframe to the second substrate structure to provide additional external connectors. In some embodiments, at least one of the first or second subassemblies is fabricated to be non-insulated and includes at least one leadframe to provide an external connector. A heatsink may be coupled to the leadframe to improve thermal management. In some embodiments, at least one of the first or second POLs are fabricated as a two-layer POL.

At step 1006, the method 1000 includes coupling the second subassembly to the first subassembly such that the second subassembly is vertically disposed over the first subassembly with the second POL oriented toward the first POL. Electrical connections are formed between the first and second subassemblies to define a stacked back-to-back power module. In some embodiments, a heat spreader and/or shim is placed between the first and second POLs and sintered to the respective metal interconnects to enhance thermal coupling and structural integrity. In other embodiments, circuitry configured to provide surge protection (e.g., a metal-oxide varistor (MOV) or transient voltage suppressor) is coupled between the first and second subassemblies. In some embodiments, the method 1000 may further include coupling the surge protection circuitry between the drain leads of the subassemblies. In some embodiments, a snubber circuit comprising inductors, capacitors, and resistors may also be integrated in parallel with the surge protection circuitry. In some embodiments, the method 1000 may further include molding the stacked subassemblies using a transfer molding or injection molding process to encapsulate the module and form the final package.

Referring to FIG. 11, a schematic cross-sectional side view of an electronic component 1100 is shown according to various embodiments of these teachings. In some embodiments, the electronic component 1100 may be used for implementing a power module having a stacked back-to-back source-drain-drain-source (S-D-D-S) configuration.

As shown in FIG. 11, the electronic component 1100 includes a first subassembly 202 and a second subassembly 230 with electric connections between the first and second subassemblies 202, 230. The first subassembly 202 includes the first POL 204 that provides electrical connections to at least one semiconductor device 212 included in the first assembly. The first subassembly 202 may also include a source (S1) lead 206. The second subassembly 230 includes the second POL 232 that provides electrical connections to at least one semiconductor device 240 included in the second subassembly 230. The second subassembly 230 may also include the source (S2) lead 234 and the gate/auxiliary (I/Os) leads 210.

The second subassembly 230 is stacked relative to the first subassembly 202 such that the second POL 232 and the first POL 204 are oriented in opposing directions (i.e., face away from one another). That is, the second subassembly 230 is disposed over the first subassembly 202 with the second POL 232 and the first POL 204 oriented such that they face substantially opposite directions and with electrical connections between the first and second subassemblies 202, 230 that form the power module. In some embodiments, the second subassembly 230 is disposed over the first subassembly 202 with the second POL 232 and the first POL 204 oriented such that a side of the second POL 232 having metal interconnects 238 formed thereon faces a direction that is substantially opposite to a direction faced by a side of the first POL 204 having metal interconnects 218 formed thereon.

In the illustrated embodiment, the drain (D1) of the first subassembly 202 is coupled to the drain (D2) of the second subassembly 230. Orienting the first and second POLs 204, 232 to face opposite directions enables a convenient source-drain-drain-source (S-D-D-S) configuration given that the bottom of the semiconductor device 240 is in close proximity to the bottom of the semiconductor device 212. The vertically stacked semiconductor devices having POLs 204, 232 in the illustrated orientation provides compact and short current paths for the drain-drain (D-D) connection. In some embodiments, the illustrated orientation can also provide reduced parasitic inductance, flexible thermal management, and multiple parallel electrical connection mechanisms.

In some embodiments, the electrical component 1100 includes a heat spreader or shim 250 positioned between the first subassembly 202 and the second subassembly 230. More specifically, in some embodiments, the heat spreader or shim 250 may be disposed between the at least one semiconductor device 212 included in the first subassembly 202 and the at least one semiconductor device 240 included in the second subassembly 230. The heat spreader or shim 250 (which forms an intermediate layer) may enhance thermal management by facilitating heat dissipation away from the power semiconductor devices 212, 240 during operation. In some embodiments, the heat spreader or shim 250 is also configured to operate as a lead 208 for the midpoint D1D2 and provides an external connector of the power module.

The first POL 204 of the first subassembly 202 includes one or more dielectric layers 214 having conductive vias 216 and patterned metal interconnects 218 formed thereon. The metal interconnects 218, e.g., formed of copper or copper alloys, can be patterned to define the desired routing paths across the first POL 204 to route electrical signals and power between terminals of the least one power semiconductor device 212 and external leads. The vias 216 are conductive openings formed through the dielectric layers 214 to electrically connect different levels of the interconnect structure, enabling vertical signal and power routing between terminals of the power semiconductor device 212 and the drain/source leads or leadframes. The vias 216 may be filled or plated with conductive materials such as copper to ensure low-resistance electrical continuity. In some embodiments, one or more copper shims (not shown) may be positioned within the first subassembly 202 to enhance both electrical conduction and thermal dissipation.

The second POL 232 of the second subassembly 230 includes one or more dielectric layers 236 having conductive vias 237 and patterned metal interconnects 238 formed thereon. The metal interconnects 238, e.g., formed of copper or copper alloys, can be patterned to define the desired routing paths across the second POL 232 to route electrical signals and power between terminals of the least one power semiconductor device 240 and external leads. The vias 237 are conductive openings formed through the dielectric layers 236 to electrically connect different levels of the interconnect structure, enabling vertical signal and power routing between terminals of the power semiconductor device 240 and the drain/source leads or leadframes. The vias 237 may be filled or plated with conductive materials such as copper to ensure low-resistance electrical continuity. In some embodiments, one or more copper shims (not shown) may be positioned within the second subassembly 230 to enhance both electrical conduction and thermal dissipation.

In some embodiments, the first POL 204 is mounted on a first substrate structure 219 that includes a ceramic-metal substrate 222, which may be formed from thermally conductive and electrically insulating materials such as silicon nitride (Si₃N₄) or aluminum nitride (AIN). The substrate 222 can include copper layers 224 on both its top and/or bottom surfaces, forming a direct bonded copper (DBC) substrate to facilitate efficient thermal dissipation and electrical conduction. In some embodiments, the first POL 204 may be bonded (e.g., mechanically and electrically) to the first substrate structure 219 using a high-performance attachment layer as described above.

In some embodiments, the second POL 232 is bonded to a second substrate structure 221 that includes a ceramic-metal substrate 244, which may be formed from thermally conductive and electrically insulating materials such as silicon nitride (Si₃N₄) or aluminum nitride (AIN). The substrate 244 can include copper layers 246 on both its top and/or bottom surfaces, forming a direct bonded copper (DBC) substrate to facilitate efficient thermal dissipation and electrical conduction. In some embodiments, the second POL 232 may be bonded (e.g., mechanically and electrically) to the second substrate structure 221 using a high-performance attachment layer as described above.

In some embodiments, an insulating material 239, such as epoxy, may be used to at least partially fill gaps between and around the first and second subassemblies 202, 230.

In some embodiments, either one or both of the first and second substrate structures 219, 221 may be eliminated such that the electronic component 1100 is either fully or partially non-insulated similar to the electronic components 400, 500, 550 of FIGS. 4, 5A, and 5B described above. Furthermore, in some embodiments, any one or more of the other features described above may be incorporated into the electronic component 1100, such as for example, one or more two-layer POLs, insulated heatsinks, surge protection circuitry such as a metal-oxide varistor (MOV), etc.

Thus, as described herein, back-to-back power modules constructed from MOSFET devices may either have their sources coupled together or their drains coupled together. In accordance with various embodiments described herein, such modules are fabricated in a stacked manner. In some embodiments, such as some embodiments described with respect to FIGS. 2-9, such modules may be fabricated having POLs that physically face each other. This can be helpful for a D-S-S-D configuration because the sources may be relatively close together. In some embodiments, such as some embodiments described with respect to FIG. 11, such modules may be fabricated having POLs that physically face substantially opposite directions. This can be helpful for an S-D-D-S configuration because the drains may be relatively close together.

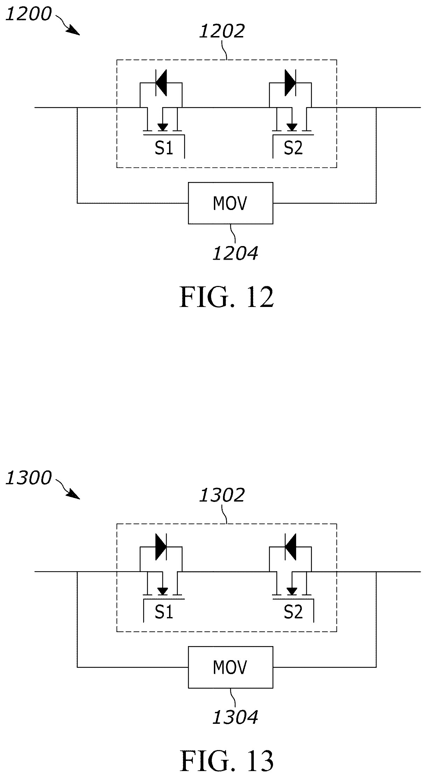

Referring now to FIGS. 12 and 13, shown are schematic diagrams of solid-state circuit breakers that each include a back-to-back power module and a metal-oxide varistor (MOV) connected in parallel. In some embodiments, the solid-state circuit breakers may be implemented and/or constructed by using one or more of the electronic components of FIGS. 2-9 and 11. FIG. 12 shows a stacked back-to-back power module 1200 as a pair of switches S1-S2 1202 in a back-to-back drain-source-source-drain (D-S-S-D) configuration, and FIG. 13 shows a stacked back-to-back power module 1300 as a pair of switches S1-S2 1302 with a back-to-back source-drain-drain-source (S-D-D-S) configuration. In each case, switch pairs S1-S2 1202, 1302 are coupled in parallel with at least one MOV 1204, 1304. In conjunction with the MOV, switch pairs S1-S2 can act as a solid-state circuit breaker. By way of example, in some embodiments, the stacked back-to-back power module 1200 with its D-S-S-D configuration may be implemented and/or constructed using any of the electronic components of FIGS. 2-9, and the stacked back-to-back power module 1300 with its S-D-D-S configuration may be implemented and/or constructed using the electronic component of FIG. 11.

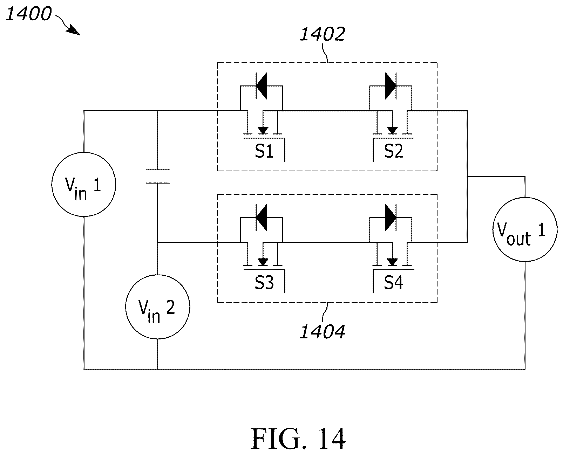

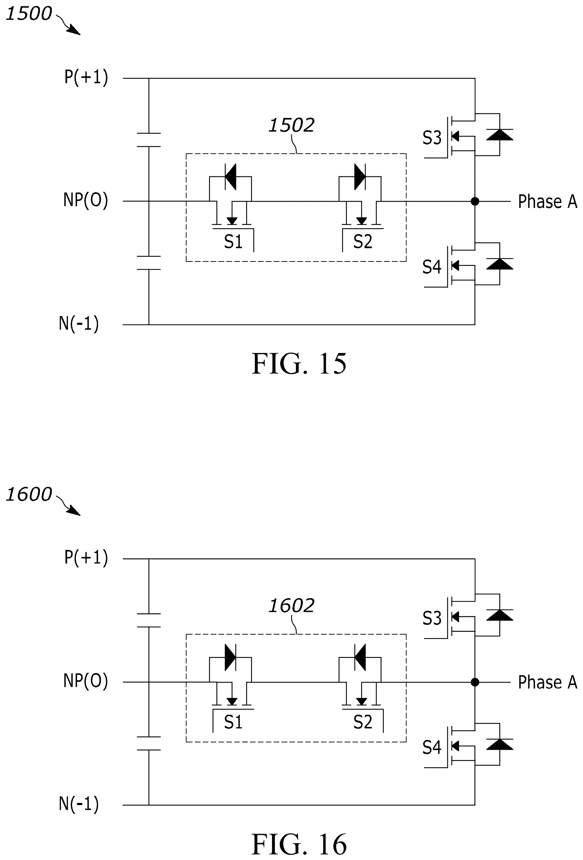

FIGS. 14-16 are schematic diagrams of converters 1400-1600 in which stacked back-to-back power module of the electronic components of FIGS. 2-9, and 11 may be incorporated. FIG. 14 illustrates two stacked back-to-back power modules as pairs of switches S1-S2 1402 and S3-S4 1404 in a two-phase to single-phase matrix converter in which two voltage inputs Vin 1, Vin 2 provide a voltage to the stacked back-to-back power modules, which are controlled to provide a single-phase voltage output Vout 1. The stacked back-to-back power modules can be utilized to achieve any level of matrix converter conversion. FIGS. 15 and 16 each illustrate a stacked back-to-back power module as a pair of switches S1-S2 in a phase leg of a T-type converter. FIG. 15 shows the stacked back-to-back power module as a pair of switches S1-S2 1502 in a back-to-back drain-source-source-drain (D-S-S-D) configuration, and FIG. 16 shows the stacked back-to-back power module as a pair of switches S1-S2 1602 with a back-to-back source-drain-drain-source (S-D-D-S) configuration. In T-type converters, the stacked back-to-back power module is employed to clamp the phase voltage to the neutral-point and provide an additional voltage level for better output voltage quality.

Beneficially embodiments of the disclosure thus provide a stacked back-to-back power module including first and second subassemblies. In some embodiments, the sources of the first and second subassemblies are coupled together, or the drains of the first and second subassemblies are coupled together. This arrangement allows the stacked back-to-back power module to act as a solid-state circuit breaker. The stacking of the two subassemblies results in a lower footprint for the stacked back-to-back power module and, therefore, a higher power density without compromising functionality. The stacked back-to-back power module may also include MOVs and/or transient voltage suppressors for voltage clamping. Further, the stacked back-to-back power module has a double side cooled option that can include three cooling layers. The stacked back-to-back power module can be used as a building block for various configurations such as, for example, solid-state circuit breakers, matrix converters, Vienna rectifiers, and T-type converters. In addition, the stacked back-to-back power module is useful for connecting different AC power systems (for example, for two-phase to single-phase conversion). The stacked back-to-back power module may be used in various industries and applications such as, for example, in the fields of propulsion and transportation (including, but not limited to automotive, locomotive, and aviation) and renewable energy (including, but not limited to, solar energy). The stacked back-to-back power module provides for simplified integration for each configuration and gate driver boards along with the reduced area requirement leading to compact design and higher power density.

Therefore, in some embodiments, a stacked back-to-back power module includes a first power overlay (POL) subassembly having a drain and a source and a second POL subassembly stacked on the first POL subassembly such that the first and second POL subassemblies form a stacked back-to-back power module. The second POL subassembly may also include a drain and a source. In some embodiments, either the drains of the first and second POL subassemblies are coupled to each other or the sources of the first and second POL subassemblies are coupled to each other.

And in some embodiments, a method of manufacturing a stacked back-to-back power module includes fabricating a first power overlay (POL) subassembly including a drain and a source and fabricating a second POL subassembly including a drain and a source. The method additionally includes coupling the second POL subassembly to the first POL subassembly to form a stacked back-to-back power module. In some embodiments, either the drains of the first and second POL subassemblies are coupled to each other or the sources of the first and second POL subassemblies are coupled to each other.

While the invention has been described in detail in connection with only a limited number of embodiments, it should be readily understood that the invention is not limited to such disclosed embodiments. Rather, the invention can be modified to incorporate any number of variations, alterations, substitutions, or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims. In the appended claims, the singular forms of "a," "an," and "the" include their corresponding plural references unless the context clearly dictates otherwise.

Further aspects of the disclosure are provided by the subject matter of the following clauses:

An electronic component comprising: a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL oriented toward the first POL and with electrical connections between the first and second subassemblies that form a power module.

The electronic component of any preceding clause, further comprising: a heat spreader and/or shim disposed between the first and second POLs.

The electronic component of any preceding clause, wherein the heat spreader and/or shim improves a thermal management of the power module and/or facilitates at least one of the electrical connections between the first and second subassemblies.

The electronic component of any preceding clause, wherein the first and second POLs each comprise a dielectric layer having vias and metal interconnects formed thereon to provide the respective electrical connections to the respective at least one semiconductor device.

The electronic component of any preceding clause, wherein: the first subassembly further includes a first substrate structure to which the at least one semiconductor device included in the first subassembly is coupled; and the second subassembly further includes a second substrate structure to which the at least one semiconductor device included in the second subassembly is coupled.

The electronic component of any preceding clause, wherein the first and second substrate structures each comprise a ceramic-metal substrate with metal layers bonded to both sides thereof.

The electronic component of any preceding clause, further comprising: at least one lead coupled to the first substrate structure to provide an external connector of the power module.

The electronic component of any preceding clause, further comprising: at least one lead coupled to the second substrate structure to provide another external connector of the power module.

The electronic component of any preceding clause, wherein at least one of the first or second subassemblies is non-insulated and further includes at least one lead to provide an external connector of the power module.

The electronic component of any preceding clause, further comprising: a heatsink coupled to the at least one lead.

The electronic component of any preceding clause, wherein at least one of the first or second POLs comprises a two-layer POL.

The electronic component of any preceding clause, further comprising: circuity coupled between the first and second subassemblies that is configured to provide surge protection.

The electronic component of any preceding clause, wherein the circuitry comprises a metal-oxide varistor (MOV).

The electronic component of any preceding clause, wherein the electrical connections between the first and second subassemblies configure the power module to operate as a solid-state circuit breaker.

The electronic component of any preceding clause, wherein the at least one semiconductor device included in each of the first and second subassemblies comprises a metal-oxide-semiconductor field-effect transistor (MOSFET).

The electronic component of any preceding clause, wherein a source of the MOSFET included in the first subassembly is coupled to a source of the MOSFET included in the second subassembly, or a drain of the MOSFET included in the first subassembly is coupled to a drain of the MOSFET included in the second subassembly.

The electronic component of any preceding clause, wherein the at least one semiconductor device included in each of the first and second subassemblies comprises an anti-parallel switch-diode pair.

A method of manufacturing an electronic component comprising: fabricating a first subassembly that includes a first power overlay (POL) that provides electrical connections to at least one semiconductor device included in the first subassembly; fabricating a second subassembly that includes a second POL that provides electrical connections to at least one semiconductor device included in the second subassembly; and coupling the second subassembly to the first subassembly such that the second subassembly is disposed over the first subassembly with the second POL oriented toward the first POL and with electrical connections between the first and second subassemblies that form a power module.

The method of any preceding clause, wherein the coupling the second subassembly to the first subassembly comprises: placing a heat spreader and/or shim between the first and second POLs.

The method of any preceding clause, wherein: the fabricating the first subassembly comprises coupling the at least one semiconductor device included in the first subassembly to a first substrate structure; and the fabricating the second subassembly comprises coupling the at least one semiconductor device included in the second subassembly to a second substrate structure.

The method of any preceding clause, wherein: the fabricating the first subassembly further comprises coupling a first leadframe to the first substrate structure; and the fabricating the second subassembly further comprises coupling a second leadframe to the second substrate structure.

The method of any preceding clause, wherein the fabricating the first subassembly and the fabricating the second subassembly comprises: fabricating at least one of the first or second subassemblies to be non-insulated and to include at least one leadframe.

The method of any preceding clause, wherein the fabricating the first subassembly and the fabricating the second subassembly further comprises: coupling a heatsink to the at least one leadframe.

The method of any preceding clause, wherein the fabricating the first subassembly and the fabricating the second subassembly comprises: fabricating at least one of the first or second POLs as a two-layer POL.

The method of any preceding clause, wherein the coupling the second subassembly to the first subassembly comprises: coupling circuity between the first and second subassemblies that is configured to provide surge protection.

The method of any preceding clause, further comprising: molding the first and second subassemblies via a transfer molding or injection molding process.

An electronic component comprising: a first subassembly comprising: a first substrate structure; at least one semiconductor device disposed on the first substrate structure; and a first power overlay (POL) disposed on the at least one semiconductor device; a second subassembly comprising: a second substrate structure; at least one semiconductor device disposed on the second substrate structure; and a second power overlay (POL) disposed on the at least one semiconductor device; wherein the second subassembly is vertically arranged above the first subassembly with the second POL oriented toward the first POL and with electrical connections between the first and second subassemblies that form a power module.

The electronic component of any preceding clause, further comprising: a heat spreader and/or shim disposed between the first and second POLs.

The electronic component of any preceding clause, wherein at least one of the first or second POLs comprises a two-layer POL.

The electronic component of any preceding clause, further comprising: circuity coupled between the first and second subassemblies that is configured to provide surge protection.

The electronic component of any preceding clause, wherein: the at least one semiconductor device included in each of the first and second subassemblies comprises a metal-oxide-semiconductor field-effect transistor (MOSFET); and a source of the MOSFET included in the first subassembly is coupled to a source of the MOSFET included in the second subassembly, or a drain of the MOSFET included in the first subassembly is coupled to a drain of the MOSFET included in the second subassembly.

An electronic component comprising: a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL and the first POL oriented such that they face substantially opposite directions and with electrical connections between the first and second subassemblies that form a power module.

The electronic component of any preceding clause, further comprising: a heat spreader and/or shim disposed between the at least one semiconductor device included in the first subassembly and the at least one semiconductor device included in the second subassembly.

The electronic component of any preceding clause, wherein the heat spreader and/or shim is configured to operate as a lead that provides an external connector of the power module.

The electronic component of any preceding clause, wherein: the at least one semiconductor device included in each of the first and second subassemblies comprises a metal-oxide-semiconductor field-effect transistor (MOSFET); and a drain of the MOSFET included in the first subassembly is coupled to a drain of the MOSFET included in the second subassembly.

The electronic component of any preceding clause, wherein the first and second POLs each comprise a dielectric layer having vias and metal interconnects formed thereon to provide the respective electrical connections to the respective at least one semiconductor device.

The electronic component of any preceding clause, wherein: the first subassembly further includes a first substrate structure attached to the first POL; and the second subassembly further includes a second substrate structure attached to the second POL.

The electronic component of any preceding clause, wherein the first and second substrate structures each comprise a ceramic-metal substrate with metal layers bonded to both sides thereof.

The electronic component of any preceding clause, further comprising: at least one lead coupled to the first substrate structure to provide an external connector of the power module.

The electronic component of any preceding clause, further comprising: at least one lead coupled to the second substrate structure to provide another external connector of the power module.

The electronic component of any preceding clause, wherein at least one of the first or second subassemblies is non-insulated and further includes at least one lead to provide an external connector of the power module.

The electronic component of any preceding clause, further comprising: a heatsink coupled to the at least one lead.

The electronic component of any preceding clause, wherein at least one of the first or second POLs comprises a two-layer POL.

The electronic component of any preceding clause, further comprising: circuity coupled between the first and second subassemblies that is configured to provide surge protection.

The electronic component of any preceding clause, wherein the circuitry comprises a metal-oxide varistor (MOV).

The electronic component of any preceding clause, wherein the electrical connections between the first and second subassemblies configure the power module to operate as a solid-state circuit breaker.

The electronic component of any preceding clause, wherein the at least one semiconductor device included in each of the first and second subassemblies comprises an anti-parallel switch-diode pair.

An electronic component comprising: a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL oriented toward the first POL and with electrical connections between the first and second subassemblies that form a power module.

The electronic component of any preceding clause, further comprising: a heat spreader and/or shim disposed between the first and second POLs, wherein the heat spreader and/or shim is configured to operate as a lead that provides an external connector of the power module.

The electronic component of any preceding clause, wherein the first and second POLs each comprise a dielectric layer having vias and metal interconnects formed thereon to provide the respective electrical connections to the respective at least one semiconductor device.

The electronic component of any preceding clause, wherein: the first subassembly further includes a first substrate structure to which the at least one semiconductor device included in the first subassembly is coupled; and the second subassembly further includes a second substrate structure to which the at least one semiconductor device included in the second subassembly is coupled.

The electronic component of any preceding clause, further comprising: at least one lead coupled to the first substrate structure to provide an external connector of the power module.

The electronic component of any preceding clause, further comprising: at least one lead coupled to the second substrate structure to provide another external connector of the power module.

The electronic component of any preceding clause, wherein at least one of the first or second subassemblies is non-insulated and further includes at least one lead to provide an external connector of the power module.

The electronic component of any preceding clause, wherein at least one of the first or second POLs comprises a two-layer POL.

The electronic component of any preceding clause, further comprising: circuity coupled between the first and second subassemblies that is configured to provide surge protection.

The electronic component of any preceding clause, wherein the electrical connections between the first and second subassemblies configure the power module to operate as a solid-state circuit breaker.

The electronic component of any preceding clause, wherein: the at least one semiconductor device included in each of the first and second subassemblies comprises a metal-oxide-semiconductor field-effect transistor (MOSFET); and a source of the MOSFET included in the first subassembly is coupled to a source of the MOSFET included in the second subassembly.

The electronic component of any preceding clause, further comprising: an insulating material to at least partially fill gaps between and around the first and second subassemblies.

A method of manufacturing an electronic component comprising: fabricating a first subassembly that includes a first power overlay (POL) that provides electrical connections to at least one semiconductor device included in the first subassembly; fabricating a second subassembly that includes a second POL that provides electrical connections to at least one semiconductor device included in the second subassembly; and coupling the second subassembly to the first subassembly such that the second subassembly is disposed over the first subassembly with the second POL oriented toward the first POL and with electrical connections between the first and second subassemblies that form a power module.

The method of any preceding clause, wherein the coupling the second subassembly to the first subassembly comprises: placing a heat spreader and/or shim between the first and second POLs.

The method of any preceding clause, wherein: the fabricating the first subassembly comprises coupling the at least one semiconductor device included in the first subassembly to a first substrate structure; and the fabricating the second subassembly comprises coupling the at least one semiconductor device included in the second subassembly to a second substrate structure.

The method of any preceding clause, wherein the fabricating the first subassembly and the fabricating the second subassembly comprises: fabricating at least one of the first or second POLs as a two-layer POL.

An electronic component comprising: a first subassembly that includes a first power overlay (POL) that provides electrical connections to at least one semiconductor device included in the first subassembly; and a second subassembly that includes a second POL that provides electrical connections to at least one semiconductor device included in the second subassembly; wherein the second subassembly is disposed over the first subassembly with the second POL and the first POL oriented such that they face substantially opposite directions and with electrical connections between the first and second subassemblies that form a power module.

The electronic component of any preceding clause, further comprising: a heat spreader and/or shim disposed between the at least one semiconductor device included in the first subassembly and the at least one semiconductor device included in the second subassembly.

The electronic component of any preceding clause, wherein the heat spreader and/or shim is configured to operate as a lead that provides an external connector of the power module.

The electronic component of any preceding clause, wherein: the at least one semiconductor device included in each of the first and second subassemblies comprises a metal-oxide-semiconductor field-effect transistor (MOSFET); and a drain of the MOSFET included in the first subassembly is coupled to a drain of the MOSFET included in the second subassembly.

A stacked half-bridge power module comprising: a first power overlay (POL) subassembly comprising: a source; and a drain; a second POL subassembly stacked on the first POL subassembly such that the first and second POL subassemblies form a half-bridge power module, the second POL subassembly comprising: a source; and a drain coupled to the source of the first POL subassembly.

The stacked half-bridge power module of any preceding clause further comprising a snubber comprising at least one capacitor.

The stacked half-bridge power module of any preceding clause further comprising at least one capacitor integrated with the first and second POL subassemblies and configured to mitigate electromagnetic interference (EMI).

The stacked half-bridge power module of any preceding clause further comprising a heat spreader coupled between the first and second POL subassemblies, the heat spreader configured to improve a thermal management of the stacked half-bridge power module.

The stacked half-bridge power module of any preceding clause further comprising at least one heatsink configured to improve a thermal management of the stacked half-bridge power module.

A method of manufacturing a stacked half-bridge power module, the method comprising: fabricating first and second power overlay (POL) subassembly comprising: a source; and a drain; fabricating a second POL subassembly comprising: a source; and a drain; coupling the second POL subassembly to the first POL subassembly either during fabrication of the second POL subassembly or after fabrication of the second POL subassembly to form a half-bridge power module with the drain of the second POL subassembly coupled to the source of the first POL subassembly.

The method of any preceding clause wherein fabricating the first POL subassembly comprises, for each of the first and second POL subassemblies: fabricating a first POL; coupling the POL to a first substrate; and coupling a first leadframe to the first substrate.

The method of any preceding clause wherein fabricating the second POL subassembly comprises: fabricating a second POL; coupling the second POL the first POL; coupling a second substrate to the second POL; and coupling a second leadframe to the second substrate.

The method of any preceding clause further comprising molding the first and second POL subassemblies via a transfer molding or injection molding process.

A stacked back-to-back power module comprising: a first power overlay (POL) subassembly comprising: a drain; and a source; a second POL subassembly stacked on the first POL subassembly such that the first and second POL subassemblies form a stacked back-to-back power module, the second POL subassembly comprising: a drain; and a source; wherein either the drains of the first and second POL subassemblies are coupled to each other or the sources of the first and second POL subassemblies are coupled to each other.

The stacked back-to-back power module of any preceding clause wherein the stacked back-to-back power module is configured to operate as a solid-state circuit breaker.

The stacked back-to-back power module of any preceding clause further comprising at least one metal-oxide varistor (MOV) integrated therein and configured to provide voltage clamping.

The stacked back-to-back power module of any preceding clause further comprising a heat spreader coupled between the first and second POL subassemblies, the heat spreader configured to improve a thermal management of the stacked back-to-back power module.

The stacked back-to-back power module of any preceding clause further comprising at least heatsink configured to improve a thermal management of the stacked back-to-back power module.

A method of manufacturing a stacked back-to-back power module, the method comprising: fabricating first and second power overlay (POL) subassembly comprising: a drain; and a source; fabricating a second POL subassembly comprising: a drain; and a source; coupling the second POL subassembly to the first POL subassembly to form a stacked back-to-back power module with either the drains of the first and second POL subassemblies coupled to each other or the sources of the first and second POL subassemblies coupled to each other.

The method of any preceding clause wherein fabricating the first and second POL subassemblies comprises, for each of the first and second POL subassemblies: fabricating a POL; coupling the POL to a substrate; and coupling a leadframe to the substrate.

The method of any preceding clause further comprising molding the first and second POL subassemblies via a transfer molding or injection molding process.

## Claims

1. An electronic component (100) comprising:
a first subassembly (102) that includes a first power overlay (POL) (104) that provides electrical connections to at least one semiconductor device (212) included in the first subassembly (102); and
a second subassembly (130) that includes a second POL (132) that provides electrical connections to at least one semiconductor device (140) included in the second subassembly (130);
wherein the second subassembly (130) is disposed over the first subassembly (102) with the second POL (132) oriented toward the first POL (104) and with electrical connections between the first and second subassemblies (102)(130) that form a power module.

2. The electronic component (100) of claim 1, further comprising:
a heat spreader and/or shim (150) disposed between the first and second POLs (104)(132), wherein the heat spreader and/or shim (150) is configured to operate as a lead that provides an external connector of the power module.

3. The electronic component (100) of any preceding claim, wherein the first and second POLs (104)(132) each comprise a dielectric layer (114)(136) having vias (116)(137) and metal interconnects (118)(138) formed thereon to provide the respective electrical connections to the respective at least one semiconductor device (112)(140).

4. The electronic component of any preceding claim, wherein:
the first subassembly (102) further includes a first substrate structure (11() to which the at least one semiconductor device (112) included in the first subassembly (102) is coupled; and
the second subassembly (130) further includes a second substrate structure (121) to which the at least one semiconductor device (140) included in the second subassembly (130) is coupled.

5. The electronic component (100) of claim 4, further comprising:
at least one lead (106) coupled to the first substrate structure (119) to provide an external connector of the power module.

6. The electronic component (100) of claim 5, further comprising:
at least one lead (134) coupled to the second substrate structure (121) to provide another external connector of the power module.

7. The electronic component (100) of any preceding claim, wherein at least one of the first or second subassemblies (102)(130) is non-insulated and further includes at least one lead (106)(108)(134) to provide an external connector of the power module.

8. The electronic component (100) of any preceding claim, wherein at least one of the first or second POLs (104)(132) comprises a two-layer POL.

9. The electronic component (100) of any preceding claim, further comprising:
circuity (170) coupled between the first and second subassemblies (102)(130) that is configured to provide surge protection.

10. The electronic component (100) of any preceding claim, wherein the electrical connections between the first and second subassemblies (102)(130) configure the power module to operate as a solid-state circuit breaker.

11. The electronic component (100) of any preceding claim, wherein:
the at least one semiconductor device (112)(140) included in each of the first and second subassemblies (102)(130) comprises a metal-oxide-semiconductor field-effect transistor (MOSFET); and
a source of the MOSFET included in the first subassembly is (102) coupled to a source of the MOSFET included in the second subassembly (130).

12. The electronic component (100) of any preceding claim, further comprising:
an insulating material (139) to at least partially fill gaps between and around the first and second subassemblies (102)(130).

13. A method of manufacturing an electronic component (100) comprising:
fabricating a first subassembly (102) that includes a first power overlay (POL) (104) that provides electrical connections to at least one semiconductor device (112) included in the first subassembly (102);
fabricating a second subassembly (130) that includes a second POL (132) that provides electrical connections to at least one semiconductor device (140) included in the second subassembly (130); and
coupling the second subassembly (130) to the first subassembly (102) such that the second subassembly (130) is disposed over the first subassembly (102) with the second POL (132) oriented toward the first POL (104) and with electrical connections between the first and second subassemblies (102)(130) that form a power module.

14. The method of claim 13, wherein:
the fabricating the first subassembly (102) comprises coupling the at least one semiconductor device (112) included in the first subassembly (102) to a first substrate structure (119); and
the fabricating the second subassembly (130) comprises coupling the at least one semiconductor device (140) included in the second subassembly (130) to a second substrate structure (121).

15. The method of claim 13, wherein the fabricating the first subassembly (102) and the fabricating the second subassembly (130) comprises:
fabricating at least one of the first or second POLs (104)(132) as a two-layer POL.
